# FASCICULE DE BREVET EUROPEEN

(11) **EP 0 407 958 B1**
(45) Date de publication et mention de la délivrance du brevet: **30.11.1994**
(21) Numéro de dépôt: 90113133.4
(22) Date de dépôt: 10.07.1990
(51) Int. Cl.: H04B 7/17

(54) **Dispositif de réception pour faisceau hertzien numérique**
Empfangsvorrichtung für Richtfunkstrecken
Reception apparatus for directional radio links

(30) Priorité: 12.07.1989 FR 8909399
(43) Date de publication de la demande: 16.01.1991
(73) Titulaire: ALCATEL TELSPACE, 92734 Nanterre Cédex (FR); ALCATEL N.V., NL-1077 XX Amsterdam (NL)
(72) Inventeur: Janer, Patrick, F-92300 Levallois-Perret (FR)
(74) Mandataire: Weinmiller, Jürgen

(56) Documents cités:
- US-A- 3 546 383
- IEEE Global Telecommunications Conference and Exhibition, Conference Record,vol. 3 of 3, 1988, pages 1741 - 1746; W. A. Conner: "Direct RF Modulation 256QAM Microwave System"

## Description

La présente invention se rapporte à un dispositif de réception pour faisceau hertzien numérique.

On désigne généralement par "faisceau hertzien numérique", le canal de transmission d'informations numériques. Ce faisceau hertzien est donc constitué d'un dispositif d'émission, d'un dispositif de réception, et de l'espace de propagation qui les sépare.

Un récepteur numérique classique se compose normalement de trois parties :
- une partie hyperfréquence qui comprend un amplificateur à faible bruit apte à réduire au maximum le facteur de bruit de l'ensemble, un mélangeur de transposition de signal hyperfréquence en fréquence intermédiaire (typiquement de 70 ou de 140 Mégahertz), et un oscillateur hyperfréquence de transposition ;
- une partie intermédiaire qui comporte un amplificateur à faible bruit, un filtre de canal, un correcteur de temps de propagation de groupe et un oscillateur de transposition, un démodulateur numérique et un oscillateur de démodulation ; et
- une partie bande de base comportant en particulier un dispositif de récupération de porteuse en fréquence intermédiaire.

Ce type de récepteur a l'avantage d'être de bande passante large, celle-ci étant limitée uniquement par la bande passante de l'amplificateur à faible bruit hyperfréquence. En revanche, il présente l'inconvénient d'avoir un grand nombre d'éléments fonctionnels, ce qui est pénalisant aussi bien du point de vue de la consommation et du prix de revient que du point de vue de l'encombrement. Par ailleurs, le filtre utilisé en fréquence intermédiaire doit posséder une symétrie arithmétique aussi bien en transmission qu'en temps de propagation de groupe, et est en conséquence de réalisation très difficile, compte tenu du fait que l'on ne sait aisément réaliser, à ces fréquences, que des filtres passe-bande à symétrie géométrique.

Il existe également, conformément au document FR-A-2 543 379, des récepteurs numériques qui, étant à démodulation directe en hyperfréquence, n'utilisent pas de transposition en fréquence intermédiaire. Un récepteur de ce type comporte deux parties :
- une partie hyperfréquence qui comprend un amplificateur à faible bruit, un démodulateur hyperfréquence, et un oscillateur hyperfréquence de démodulation ; et
- une partie bande de base qui comprend en particulier un estimateur de phase ainsi que, pour chaque voie démodulée, un amplificateur à faible bruit, un filtre, un correcteur de temps de propagation de groupe, et un amplificateur à Contrôle Automatique de Gain.

Ce type de récepteur a pour inconvénients d'être de bande passante si faible que ce récepteur n'est pratiquement utilisable que dans un seul canal de transmission. Cette bande passante est en effet limitée par la bande passante du démodulateur hyperfréquence, qui est faible car on ne sait pas réaliser de déphaseur de précision hyperfréquence qui comporte une large bande passante. En outre, ce démodulateur hyperfréquence est de réalisation complexe et de réglage difficile à effectuer.

On connaît également des dispositifs de réception pour faisceau hertzien numérique comportant successivement :
- une partie hyperfréquence comprenant un dispositif de transposition en fréquence intermédiaire ;
- une partie fréquence intermédiaire comportant un dispositif de démodulation directe du signal en fréquence intermédiaire ;
- une partie bande de base réalisant le traitement du signal et comprenant pour chacune des deux voies démodulées un filtre passe-bas.

Un tel récepteur est décrit dans l'article IEEE Global Telecommunication Conference and Exhibition, Conference Record, vol.3 of 3, 1988, page 1743, de W.A. Conner intitulé "Direct RF Modulation 256QAM Microwave System".

L'inconvénient de ce récepteur est qu'il comporte un amplificateur piloté par un système de Contrôle Automatique de Gain placé entre la partie hyperfréquence et la partie fréquence intermédiaire, c'est à dire avant démodulation et filtrage. En conséquences, le système de CAG s'accroche sur toutes les perturbations du signal reçu et l'amplification n'est donc pas contrôlée.

L'invention vise à remédier à tous ces inconvénients. Elle se rapporte à cet effet à un dispositif de réception pour faisceau hertzien numérique conforme à la revendication 1.

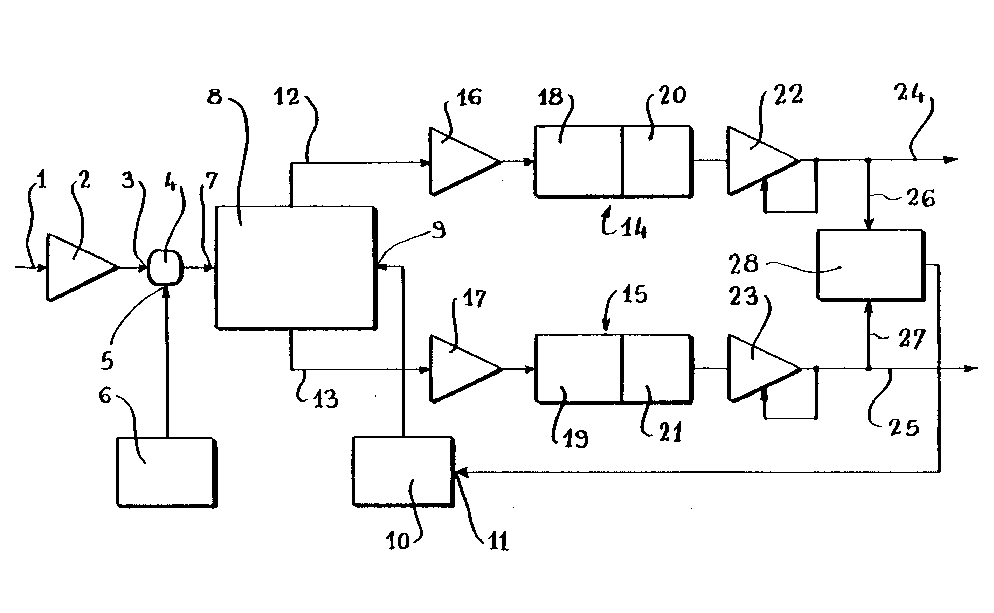

L'invention sera bien comprise, et ses avantages et autres caractéristiques ressortiront, lors de la description suivante d'un exemple non limitatif de réalisation de ce récepteur, en référence à la figure unique annexée qui en est un schéma synoptique simplifié.

En se référant à cette figure unique, le signal numérique à porteuse hyperfréquence reçu est appliqué en L à un amplificateur hyperfréquence à faible bruit 2. Un tel amplificateur a une large bande passante, et son rôle essentiel est de masquer le facteur de bruit de l'ensemble placé en aval.

Le signal de sortie de l'amplificateur 2 est appliqué sur une première entrée 3 d'un mélangeur 4, par exemple à réjection de fréquence image, de transposition en fréquence intermédiaire, ce mélangeur recevant classiquement sur sa seconde entrée 5 un signal hyperfréquence de fréquence fixe, provenant d'un oscillateur local 6.

Les éléments 2, 4 et 6 forment la partie hyperfréquence du récepteur. Le signal en sortie 7 du mélangeur de transposition 4 est un signal en fréquence intermédiaire (typiquement à 70 ou 140 Mégahertz par exemple).

Ce signal en fréquence intermédiaire ne reçoit, conformément à l'invention, aucun traitement particulier, mais est directement démodulé dans un démodulateur 8 fonctionnant à la fréquence intermédiaire, donc à fréquence fixe. Ce démodulateur 8 possède deux entrées, dont l'entrée 7 en provenance du mélangeur de transposition 4 et une entrée 9 en provenance d'un oscillateur local de démodulation 10, qui est lui-même piloté en 11 par le signal de sortie de l'estimateur de phase 28, qui sera décrit ci-après.

Le démodulateur 8 et l'oscillateur de démodulation 11 constituent la partie fréquence intermédiaire du récepteur.

Sur les deux sorties 12 et 13 du démodulateur 8 apparaissent les deux voies de signaux démodulés en bande de base 14, 15 (dans cet exemple il s'agit d'une modulation à quatre états de phase).

Chacune de ces voies 14, 15 comporte un dispositif classique de traitement du signal en bande de base, comprenant notamment :
. un amplificateur à faible bruit : respectivement 16 et 17 ;
. un filtre passe-bas : respectivement 18 et 19 ;
. un correcteur de temps de propagation de groupe : respectivement 20 et 21 ;
. un amplificateur à Contrôle Automatique de gain, ou CAG : respectivement 22 et 23.

Les sorties 24 et 25 des deux voies 14, 15 sont respectivement appliquées aux entrées 26 et 27 de l'estimateur de phase précité 28. Ces sorties 24 et 25 sont les sorties du récepteur.

Les amplificateurs à CAG 22 et 23 sont placés en bande de base après démodulation et après filtrage bande de base. Le système de CAG ne peut donc pas s'accrocher sur un éventuel perturbateur car le signal appliqué à l'entrée de chaque amplificateur à CAG est filtré, contrairement à l'enseignement du document IEEE précité.

Ce récepteur comporte donc une transposition en fréquence intermédiaire, ce qui lui permet d'avoir une large bande passante, mais l'utilisation de cette fréquence intermédiaire est uniquement limitée à la démodulation du signal, le traitement de ce dernier se faisant en bande de base, ce qui est très avantageux du point de vue du coût de la réalisation, de la maintenance, et de la consommation. Comme il va de soi, l'invention n'est pas limitée à l'exemple de réalisation qui vient d'être décrit. C'est ainsi qu'en variante, c'est l'oscillateur hyperfréquence de transposition 6 qui pourrait être piloté par l'estimateur de phase 28, tandis que l'oscillateur de démodulation 10 serait utilisé en libre. L'oscillateur hyperfréquence 6 pourrait être synthétisé. Ce récepteur convient pareillement à des modulations complexes (à 16, 64, voire même 256 états de phase) tout en conservant ses propriétés de large bande passante : la démodulation, qui est effectuée à fréquence fixe, peut être réglée une fois pour toutes de manière optimale, et le filtrage, qui s'effectue en bande de base, peut être aisément réalisé par l'utilisation de filtres passe-bas dont il est aisé de contrôler parfaitement les fréquences de coupure.

## Revendications

1. Dispositif de réception pour faisceau hertzien numérique comportant successivement :
- une partie hyperfréquence (2, 4, 6) comprenant un dispositif (4, 6) de transposition en fréquence intermédiaire;
- une partie fréquence intermédiaire comportant un dispositif (8, 10) de démodulation directe du signal en fréquence intermédiaire ;
- une partie bande de base (14, 15, 28) réalisant le traitement du signal et comprenant pour chacune des deux voies démodulées (14, 15) un filtre passe-bas (18, 19),
caractérisé en ce que chacune desdites voies démodulées (14, 15) comporte :
- un amplificateur à faible bruit (16, 17) ;
- un desdits filtres passe-bas (18, 19) ;
- un correcteur de temps de propagation de groupe (20, 21) ;
- un amplificateur à Contrôle Automatique de Gain (22, 23) placé après un desdits filtres passe-bas (18, 19),
les sorties desdites voies (14, 15) étant respectivement appliquées aux entrées d'un estimateur de phase (28) compris dans ladite partie bande de base (14, 15, 28).

2. Dispositif selon la revendication 1, caractérisé en ce que ladite partie fréquence intermédiaire (8, 10) comporte un oscillateur local de démodulation (10) piloté par ledit estimateur de phase (28) compris dans ladite partie bande de base (14, 15, 28).

3. Dispositif selon la revendication 1, caractérisé en ce que ladite partie hyperfréquence (2, 4, 6) comporte un oscillateur local de transposition (6) piloté par ledit estimateur de phase (28) compris dans ladite partie bande de base (14, 15, 28).

4. Dispositif selon la revendication 3, caractérisé en ce que ledit oscillateur de transposition (6) est un oscillateur synthétisé.

## Patentansprüche

1. Empfangsvorrichtung für eine digitale Richtfunkstrecke, die nacheinander aufweist:
- einen Hochfrequenzteil (2, 4, 6) mit einer Vorrichtung (4, 6) zur Umsetzung in das Zwischenfrequenzband,
- einen Zwischenfrequenzteil mit einer Vorrichtung (8, 10) zur direkten Demodulation des Zwischenfrequenzsignals,
- einen Basisbandteil (14, 15, 28), der die Verarbeitung des Signals durchführt und für jeden der beiden demodulierten Kanäle (14, 15) ein Tiefpaßfilter (18, 19) enthält,
dadurch gekennzeichnet, daß jeder der demodulierten Kanäle (14, 15)
- einen rauscharmen Verstärker (16, 17),
- eines der Tiefpaßfilter (18, 19),
- ein Korrekturorgan für die Gruppenlaufzeit (20, 21),
- und einen Verstärker mit automatischer Verstärkungsregelung (22, 23) enthält, der hinter je einem der Tiefpaßfilter (18, 19) angeordnet ist, wobei die Ausgänge dieser Kanäle (14, 15) an je einen Eingang eines Phasenschätzorgans (28) angeschlossen sind, das sich im Basisbandteil (14, 15, 28) befindet.

2. Vorrichtung nach Anspruch 1, dadurch gekennzeichnet, daß der Zwischenfrequenzteil (8, 10) einen örtlichen Demodulationsoszillator (10) aufweist, der von dem Phasenschätzorgan (28) im Basisbandteil (14, 15, 28) gesteuert wird.

3. Vorrichtung nach Anspruch 1, dadurch gekennzeichnet, daß der Hochfrequenzteil (2, 4, 6) einen örtlichen Umsetzungsoszillator (6) aufweist, der von dem im Basisbandteil (14, 15, 28) enthaltenen Phasenschätzorgan (28) gesteuert wird.

4. Vorrichtung nach Anspruch 3, dadurch gekennzeichnet, daß der Umsetzungsoszillator (6) ein synthetisierter Oszillator ist.

## Claims

1. A digital radio link receiving device successively comprising:
- a microwave frequency part (2, 4, 6) comprising a device (4, 6) for transposition to an intermediate frequency;
- an intermediate frequency part including a device (8, 10) for direct demodulation of the signal at intermediate frequency; and
- a baseband part (14, 15, 28) performing signal processing and comprising for each of the two demodulated channels (14, 15) a low-pass filter (18, 19), characterised in that each of said demodulated channels (14, 15) includes:
- a low-noise amplifier (16, 17),
- one of said lowpass filters (18, 19),
- a group propagation delay corrector (20, 21),
- an automatic gain control amplifier (22, 23) on the output side of one of said low-pass filters (18, 19),
the outputs from said channels (14, 15) being respectively applied to the inputs of a phase estimator (28) in said baseband part (14, 15, 28).

2. Device according to claim 1 characterised in that said intermediate frequency part (8, 10) includes a demodulation local oscillator (10) controlled by said phase estimator (28) of said baseband part (14, 15, 28).

3. Device according to claim 1 characterised in that said microwave frequency part (2, 4, 6) includes a transposition local oscillator (6) controlled by said phase estimator (28) of said baseband part (14, 15, 28).

4. Device according to claim 3 characterised in that said transposition local oscillator (6) is a frequency synthesiser type oscillator.
